# EUROPEAN PATENT SPECIFICATION

(11) **EP 4 072 252 B1**
(45) Date of publication and mention of the grant of the patent: **25.11.2026**
(21) Application number: 21167517.8
(22) Date of filing: 08.04.2021
(51) Int. Cl.: H05K 3/00, H05K 3/40, H05K 3/42, H05K 3/06, H05K 3/14, H05K 3/16

(54) **METHOD FOR MANUFACTURING A SHEET WITH DOUBLE-SIDED STRUCTURED CONDUCTING LAYERS FOR ELECTRONIC APPLICATIONS**
VERFAHREN ZUR HERSTELLUNG EINER FOLIE MIT DOPPELSEITIGEN STRUKTURIERTEN LEITENDEN SCHICHTEN FÜR ELEKTRONISCHE ANWENDUNGEN
PROCÉDÉ DE FABRICATION D'UNE FEUILLE COMPORTANT DES COUCHES CONDUCTRICES STRUCTURÉES DOUBLE FACE POUR APPLICATIONS ÉLECTRONIQUES

(43) Date of publication of application: 12.10.2022
(73) Proprietor: Fraunhofer-Gesellschaft zur Förderung der angewandten Forschung e.V., 80686 München (DE)
(72) Inventor: ALTANA, Antonio, 80686 München (DE); YAKUSHENKO, Alexey, 80686 München (DE); IAKOVLEV, Aleksandr, 80686 München (DE)
(74) Representative: Hersina, Günter

(56) References cited:
- WO-A1-2014/058264
- DE-U1- 29 600 936
- US-A- 5 023 994
- US-A- 5 406 034
- US-A1- 2005 226 995
- US-A1- 2020 389 980

## Description

### Technical Field of the invention

Embodiments according to the invention relate to a method for manufacturing a sheet with double-sided structured conducting layers for electronic applications.

### Background of the invention

The standard solution up to now for manufacturing a structured conducting layer on a flexible substrate is to deposit a thick layer of material on one side of the substrate, usually involving a process of depositing a thin (50-500 nm) seed metal layer first and galvanizing it to a thicker layer of 5-10 µm; alternatively, a thick metal layer can be laminated onto a foil or a rigid substrate: alternatively, a thick conductive layer (e.g. carbon or copper or silver) can be printed (e.g. screen-printing) onto the substrate. Then a hole in the substrate is drilled from the other side by laser or by standard drilling, utilizing the thick metal layer as a drill stop. The resulted via is then cleaned with a plasma treatment to reduce the pollution by soot and/or melted polymer of ablated substrate around the hole and filled with a conductive material either through a sputtering/evaporation process or through a printing process in order to connect to the other side of the substrate.

Problems:
- It is necessary to have a thick stopping layer on the back side of the substrate. A thin layer can be easily destroyed during the via drilling process
- If the via drilling process creates a profile around the hole, due to the melted material, it does not allow to obtain a uniform thin layer deposition and leads to a break in a conducting line.
- A good electrical contact is not possible without a subsequent surface cleaning. The metal layer on the backside is damaged by the laser drilling. Therefore, it has to be thick.
- The thicker the layer, the worse is the resolution and the flexibility
- A lot of wasted material

The document US5406034A discloses a circuit board having stepped vias. Large holes are punched in a predetermined pattern in two insulating sheets and small holes are punched in the same pattern in another insulating sheet. The sheets are juxtaposed so that the sheet with the smaller holes is between the other sheets and corresponding holes from the respective sheets are aligned. The sheets are pressed together to form an integral substrate. Metallization is applied from one side of the substrate, then metallization is applied to the substrate from the other side.

The document US5023994A discloses a method of forming a microwave integrated circuit substrate which includes via holes connecting the upper and lower surfaces of the substrate in which the upper end of the via hole is closed by a conductive membrane.

The document WO2014058264A1 discloses a printed circuit board printing apparatus for simultaneously forming a conduction line on a circuit pattern and inside a through-hole, comprising a screen printing apparatus for printing a circuit pattern on an insulation layer constituting a printed circuit board by using a conductive paste; and a suction apparatus disposed on the bottom surface of the insulation layer, for suctioning the paste downward so that the conductive paste is printed inside a through-hole for sending an electric current to the circuit pattern formed on the top and bottom surfaces of the insulation layer.

The document US2020389980A1 discloses a flexible circuit board including a substrate with a first side and an opposing second side, wherein the substrate is of a colorless polyimide; first and second circuit patterns formed by deposition of ink on the first and second sides, respectively; at least one opening to interconnect the first and second circuit patterns; and first and second cover layers applied on the first and second circuit patterns, respectively, wherein the first and second cover layers are of a colorless polyimide.

Therefore, it is desired to create a concept, which makes a better compromise between obtaining high resolution structures on a thin conductive layer and providing electrical connections between both sides of a substrate to enable double-sided conducting structured flexible foils/hard plates. Additionally, it might be desired to get an efficient method for manufacturing sheets, e.g., the flexible foils or hard plates, with double-sided conducting structure for thick and thin conductive layers.

This is achieved by the subject-matter of the independent claims of the present application.

Further embodiments according to the invention are defined by the subject-matter of the dependent claims of the present application.

### Summary of the Invention

In accordance with an aspect of the present invention, the inventors of the present application realized that one problem encountered when trying to manufacture a sheet with conducting structures on both sides, stems from the fact that a thin conductive layer on the substrate would be destroyed during formation of a through-hole, e.g., a via, in the substrate. It is necessary to have a thick conductive layer on one side of the substrate as a stopping layer for forming of a through-hole beginning from the opposite side, to prevent destroying the conductive layer at the forming of the through-hole. According to this aspect of the present application, this difficulty is overcome by forming the through-hole in the substrate before depositing the conductive material on the substrate. The inventors found, that it is advantageous that the conductive material, e.g., formed to conducting traces, is not present at the forming of the holes. This is based on the idea that the sheet can be manufactured efficiently, if the through-hole can be formed without having to pay attention to not destroying or damaging the conductive layer on the substrate. It was found that a surface profile of the through-holes can be achieved, which surface profile enables a uniform deposition of a thin conductive layer. Additionally, the formed through-holes can be cleaned easily, efficiently and thoroughly, for which reason it is possible to achieve a good electrical connectivity between the two opposite sides of the substrate even for a thin conductive layer on the walls of the through-hole. Thus it is not necessary to waste conductive material and use excessive etching chemicals for removing the extra conducting material, if a thin layer is sufficient for the application of the sheet. This is due to the fact that it is currently always necessary to deposit a thick layer of conductive material on the substrate. With the proposed method it is possible to manufacture a sheet with conducting traces of the needed thickness.

Accordingly, in accordance with this aspect of the present application, a method comprises providing an electrically insulating substrate and forming a through-hole in the substrate between a first and a second main surface region of the substrate. Additionally, the method comprises depositing conductive material on the first main surface region of the substrate, so that walls of the through-hole are covered by the conductive material; and depositing further conductive material on the second main surface region of the substrate. The method is part of a sheet-to-sheet process, a roll-to-sheet process or a roll-to-roll process. In context with the proposed method especially the roll-to-roll process is advantageous since an efficient manufacturing of the sheet with the conductive traces on opposite sides of the substrate can be achieved. The roll-to-roll process is enabled by the proposed method due to the fact that the method allows the usage of a substrate with flexible material and the structured deposition of thin conductive traces on the main surface regions of the substrate. According to a preferred embodiment for the roll-to-roll process, the substrate has a thickness of at most 250 µm and for the sheet-to-sheet process it is possible to use thicker substrates, e.g., with a thickness at most being 5 mm.

Accordingly, in accordance with this aspect of the present application, the method comprises providing the electrically insulating substrate. The electrically insulating substrate will be abbreviated in the following by substrate. The substrate comprises, for example, a polymer material, ceramic material or glass material. The method comprises forming the through-hole, e.g., a via, in the substrate between a first and a second main surface region of the substrate. Optionally the method comprises forming two or more through-holes or multiple through-holes in the substrate between the first and the second main surface region of the substrate. The first main surface region of the substrate is, for example, located opposite of the second main surface region of the substrate. The through-hole might be formed removing material of the substrate beginning on the first main surface region of the substrate and ending at the second main surface region of the substrate. Additionally, the method may comprise structured deposition (depositing) of the conductive material on the first main surface region of the substrate, so that walls of the through-hole are covered by the conductive material and so that first conductive traces are formed on the first main surface region of the substrate. Moreover, the method may comprise structured deposition (depositing) of the further conductive material on the second main surface region of the substrate so that second conductive traces are formed on the second main surface region of the substrate.

The further conductive material might be the same material as the conductive material deposited on the first main surface region of the substrate. Alternatively, two different conductive materials might be deposited on the first main surface region of the substrate and the second main surface region of the substrate. In this case, the conductive material on the first main surface region might be denominated as first conductive material and the further conductive material on the second main surface region might be denominated as second conductive material.

The structured deposition (depositing) might be understood as a combination of deposition of material, e.g., of the conductive material or of the further conductive material, and of structuring of the material. At the structured deposition, the depositing and the structuring might be performed in one step or in separate steps. In other words, the structured deposition might be understood as a depositing and subsequent structuring, e.g., deposition using sputtering or evaporation and a subsequent structuring using lithography, or as depositing of the material in a structured manner without any additional structuring step, e.g., by printing.

According to an embodiment, the substrate comprises a flexible, insulating material so that the substrate has at least in some areas a target bending radius between 0.5 mm and 5 mm. Such a flexible, insulating material, for example, is a polymer material. The flexibility of the substrate might depend on a Young's modulus of the material of the substrate and on the thickness of the substrate. To achieve a target bending radius between 0.5 mm and 5 mm the substrate, for example, has preferably a thickness between 6 µm and 500 µm, e.g., 20 µm, 30 µm, 50 µm, 100 µm, 250 µm or 300 µm. By using the flexible material, the substrate can be bent up to the target bending radius without electrically damaging or mechanically damaging the first conductive traces and the second conductive traces. The flexible material prevents or reduces a breakage of the first conductive traces and/or the second conductive traces, a loosening of a contact or a breakage of the conductive material on the walls of the through-hole up to a target bending radius between 0.5 mm and 5 mm.

According to an embodiment, the structured deposition (depositing) of the conductive material on the first main surface region of the substrate is performed so that the first conductive traces have a thickness between 20 nm and 1 µm. Additionally or alternatively, the structured deposition (depositing) of the further conductive material on the second main surface region of the substrate is performed so that the second conductive traces have a thickness between 20 nm and 1 µm. Conductive traces with a thickness between 20 nm and 1 µm, e.g.,30 nm, 50 nm, 100 nm, 150 nm, 200 nm, 250nm, 300 nm or 500 nm, are herein understood as thin conductive traces. In other words, the conductive material is structurally deposited on the substrate as a thin layer. Due to the special manufacturing method, it is possible to directly produce thin conductive traces without wasting material. The proposed method is highly efficient in producing conductive traces with a thickness between 20 nm and 1 µm by the structured deposition due to the fact that it is not necessary to remove material after the structured deposition to achieve the target thickness between 20 nm and 1 µm. With the proposed method wasted material can be reduced, manufacturing steps can be reduced and manufacturing costs can be reduced. This is due to the fact that the method enables to fabricate conductive traces with a thickness between 100 nm and 1 µm, for which reason it is not necessary to remove material form a thick layer to obtain thin conductive traces.

According to an embodiment, the through-hole is formed by cold laser ablation using an ultrashort laser (nanosecond, picosecond, femtosecond source). Alternatively, the through-hole can be formed by a standard drilling.

According to an embodiment, the substrate comprises a first protective foil adhered to the second main surface region of the substrate, e.g., the first protective foil covers the second main surface region of the substrate. Additionally, the method comprises removing the first protective foil from the second main surface region of the substrate after the forming of the through-hole in the substrate. The presence of the protective foil during the step of forming the through-hole in the substrate has the advantage that the forming results in a clean and smooth profile of the through-hole. This enables a smooth and uniform deposition of the conductive material on the walls of the through-hole, for this reason it is possible to deposit only a thin layer of conductive material on the substrate and achieving a nonetheless good electrical connectivity by the through-hole between the first conductive traces and the second conductive traces. Thus, by using the first protective foil in the proposed method it is possible to produce thin conductive traces as well as thick conductive traces.

Additionally, the substrate, for example, comprises a second protective foil adhered to the first main surface region of the substrate. Thus, on both main surface regions, i.e., on the first and the second main surface region, a protective foil is adhered to. In other words, the first and the second main surface region of the substrate are covered by a protective foil, i.e., the first and the second protective foil. The method comprises removing the second protective foil from the first main surface region of the substrate after the forming of the through-hole in the substrate. The first protective foil and the second protective foil might be removed consecutively or at the same time. The first and the second protective foil might be removed from the respective main surface region of the substrate after the forming of the through-hole in the substrate and before an optional cleaning of the substrate with the through-hole. By using the first protective foil as well as the second protective foil, the profile of the formed through-hole can be improved further, for which reason it might be possible to deposit uniformly a thinner layer on the walls of the through-hole compared to only using one protective foil adhered to the second main surface region. It might be possible to manufacture a high resolution sheet with conductive traces on both sides, i.e. the first main surface region and the second main surface region of the substrate.

The usage of the first protective foil and/or the second protective foil results in a high quality laser profile for the through-hole. Additionally, the first protective foil and/or the second protective foil provide a good protection of the substrate from dirt and scratches on the surface, i.e., on the first main surface region and/or on the second main surface region.

According to an embodiment, the method comprises cleaning the substrate with the through-hole before the structured deposition (depositing) of the conductive material on the first main surface region of the substrate and the structured deposition (depositing) of the further conductive material on the second main surface region of the substrate. The substrate is cleaned before a conductive layer is deposited on the substrate, for which reason the through-holes are not closed at one side by such a conductive layer. The holes, especially the walls of the through-holes, can be thoroughly cleaned, due to an opening at both sides, i.e. on the first and the second main surface region of the substrate. By this cleaning the surface quality of the walls of the through-hole might be increased improving the structured deposition of the conductive material and in doing so, improving an electrical connectivity between the first conductive traces and the second conductive traces. The cleaning reduces the pollution by soot and/or melted polymer of ablated substrate around the hole.

According to an embodiment, the cleaning of the substrate with the through-hole is performed using an ultra-sonic bath and/or using plasma surface cleaning.

According to an embodiment, the structured depositing of the conductive material on the first main surface region of the substrate is performed by printing, e.g., screen printing, using the through-hole in the substrate as reference for alignment of the first conductive traces. Additionally or alternatively, the structured depositing of the further conductive material on the second main surface region of the substrate is performed by printing, e.g., screen printing, using the through-hole in the substrate as reference for alignment of a second conductive traces. In this case, the structured deposition is performed in one single step, namely printing, where the conductive material is deposited on the respective main surface region of the substrate in a structured manner to directly form the first conductive traces at the depositing of the conductive material. The through-holes can be used to correctly print the respective conductive traces, i.e., the first or the second conductive traces, on the respective main surface region of the substrate, i.e., the first or the second main surface region of the substrate. Thus, a highly efficient method is provided where the conductive traces can be printed directly on the substrate with high accuracy.

According to an embodiment, the structured deposition (depositing) of the conductive material on the first main surface region of the substrate is performed by depositing the conductive material on the first main surface region of the substrate to cover the entire first main surface region of the substrate with a first layer of the conductive material and structuring the first layer of the conductive material to form the first conductive traces using the through-hole in a substrate as reference for alignment of the first conductive traces. Additionally or alternatively, the structured deposition (depositing) of the further conductive material on the second main surface region of the substrate, for example, is performed by depositing the further conductive material on the second main surface region of the substrate to cover the entire second main surface region of the substrate with a second layer of the further conductive material and structuring the second layer of the further conductive material to form the second conductive traces using the through-hole in the substrate for reference for alignment of the second conductive traces. This structured deposition to produce the first conductive traces and the second conductive traces is performed into separate consecutive steps, namely the depositing and the structuring. At such a structured deposition, the depositing is always followed by a structuring of the layer deposited on the respective main surface region of the substrate.

In the case of such a two-step structured deposition, the depositing of the conductive material on the first main surface region of the substrate to form the first layer of the conductive material is performed by sputtering or evaporation. Additionally or alternatively, the depositing of the further conductive material on the second main surface region of the substrate to form the second layer of the further conductive material is performed by sputtering or evaporation. By using sputtering or evaporation for the depositing of the conductive material, the method can efficiently and conformally cover the whole respective main surface region of the substrate and especially the walls and the edges of the through-hole.

According to an embodiment, at the two-step structured deposition, the structuring of the first layer of the conductive material and/or the structuring of the second layer of the further conductive material is performed by lithography.

According to an embodiment, one of the conductive traces, e.g., the first conductive traces or the second conductive traces, can be produced by the structured deposition being the printing and the other conductive traces can be produced by the structured deposition by first depositing the conductive material and afterwards structuring the deposited conductive layer on the substrate.

Another embodiment is related to a sheet for double-sided electronics, manufactured by the method described herein. The sheet comprises a non-conducting substrate with a through-hole electrically connecting first conductive traces on a first main surface region of the substrate with second conductive traces on a second main surface region of the substrate.

The sheet, as described above, is based on the same consideration as the above-described method for manufacturing same. The sheet can by the way be completed with all features and/or functionalities, which are also described with respect to the method.

### Brief Description of the Drawings

Any examples explained herein that do not have all of the features, or equivalents thereof, of any of the independent claims are provided to facilitate understanding of the invention.

The drawings are not necessarily to scale; emphasis instead generally being placed upon illustrating the principles of the invention. In the following description, various embodiments of the invention are described with reference to the following drawings, in which:
- Fig. 1a: shows a block diagram of a method, according to an embodiment;
- Fig. 1b: shows schematically an embodiment of a sheet with conductive material on two opposite sides of a substrate, manufactured using the method of Fig. 1a;
- Fig. 2a: shows a block diagram of a method, which forms conductive traces on opposite sides of a substrate, according to an embodiment;
- Fig. 2b: shows schematically an embodiment of a sheet with conductive traces on opposite sides of a substrate manufactured using the method of Fig. 2a;
- Fig. 3: show a block diagram of a method using sputtering and/or evaporation, according to an embodiment;
- Fig. 4a: shows a block diagram of a method using printing, according to an embodiment;
- Fig. 4b: shows schematically an embodiment of a sheet with conductive traces on opposite sides of a substrate manufactured using the method of Fig. 4a; and
- Fig. 5: shows schematically an embodiment of the method for manufacturing a sheet with conductive traces on opposite sides of a substrate as a roll-to-roll process.

### Detailed Description of the Embodiments

Equal or equivalent elements or elements with equal or equivalent functionality are denoted in the following description by equal or equivalent reference numerals even if occurring in different figures.

In the following description, a plurality of details is set forth to provide a more thorough explanation of embodiments of the present invention. However, it will be apparent to those skilled in the art that embodiments of the present invention may be practiced without these specific details. In other instances, well-known structures and devices are shown in block diagram form rather than in detail in order to avoid obscuring embodiments of the present invention. In addition, features of the different embodiments described herein after may be combined with each other, unless specifically noted otherwise.

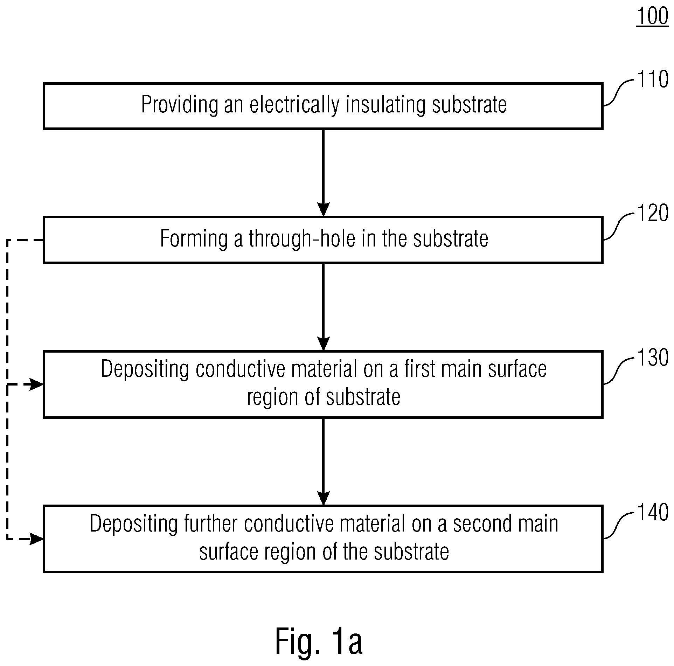

Fig. 1a shows a method 100 comprising providing 110 an electrically insulating substrate 210 and forming 120 a through-hole 220, e.g. a via, in the substrate 210 between a first 212 and a second 214 main surface region of the substrate 210. Additionally, the method 100 comprises depositing 130 conductive material 232 on the first main surface region 212 of the substrate 210, so that walls 222 of the through-hole 220 are covered by the conductive material 232. At the same time or in a subsequent step, the method 100 comprises depositing 140 further conductive material 242 on the second main surface region 214 of the substrate 210.

It is possible that the complete through-hole 220 is filled with the conductive material at the depositing 130. However, it is sufficient to cover the walls 222 of the through-hole 220 with a thin layer of the conductive material, e.g., with a thickness between 20 nm and 1 µm. To cover the walls 222 only with the thin layer of the conductive material has the advantage that the through-hole 220 does only marginally influence a flexibility of the manufactured sheet 200 and that the through-hole 220 provides at the same time a good electrical connection between the conductive material on the first 212 and the second 214 main surface region of the substrate 210.

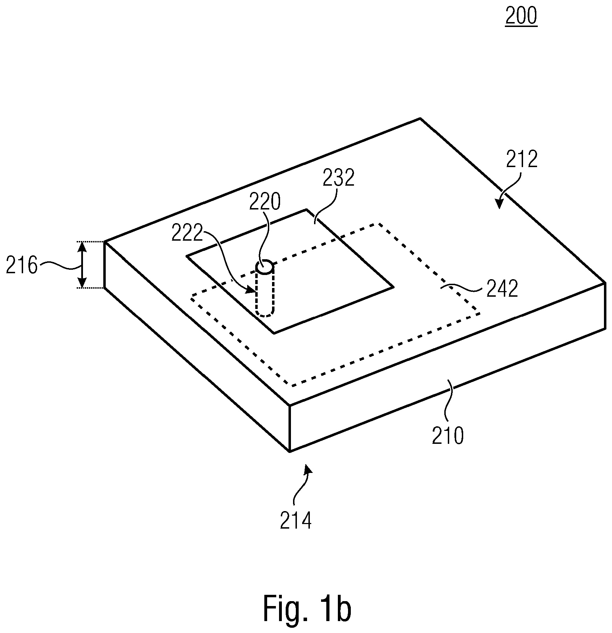

Fig. 1b shows an example of a sheet 200 with conductive material on the first main surface region 212 of the substrate 210 and with further conductive material on the second main surface region 214 of the substrate. The sheet 200, shown in Fig. 1b, can be manufactured by the method 100 in Fig, 1a.

The electrically insulating substrate 210, for example, does not comprise any conductive element or layer. No conductive layer, for example, is deposited on the electrically insulating substrate 210 before the forming 120 of the through-hole 220.

According to an embodiment, the depositing 130 of the conductive material 232 and the depositing 140 of the further conductive material 242 is performed, so that the through-hole 220 provides a conductive connection between the conductive material 232 on the first main surface region 212 of the substrate 210 and the further conductive material 242 on the second main surface region 214 of the substrate 210. The conductive connection is provided by a layer of the conductive material 232 on the walls 222 of the through hole 220.

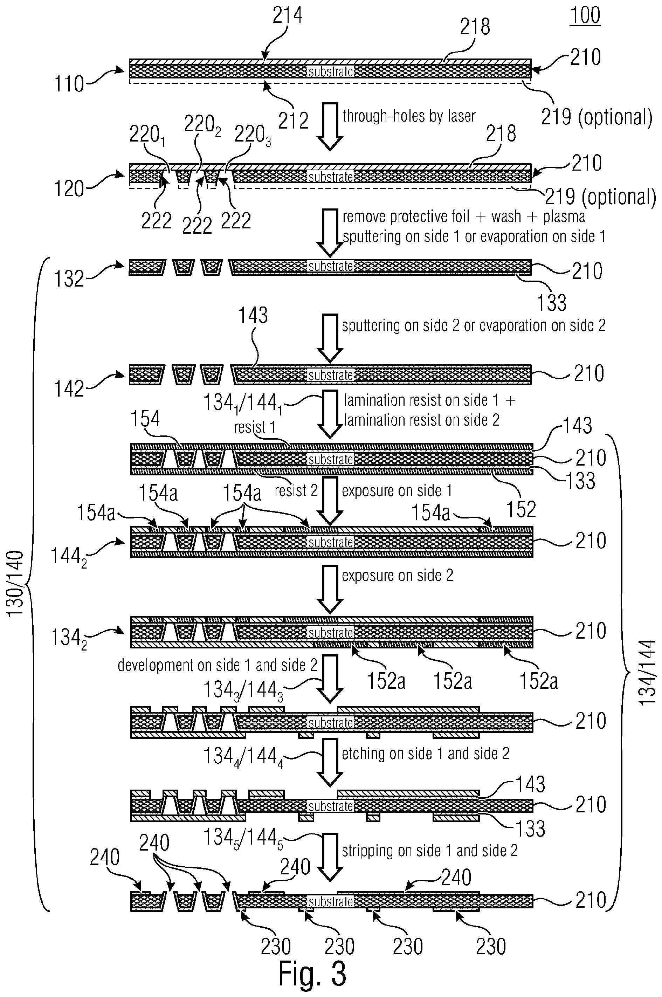

According to an embodiment, the depositing 130 might correspond to the depositing 132 described with respect to Fig. 3. Additionally, or alternatively, the depositing 140 might correspond to the depositing 142 described with respect to Fig. 3. In this case, the method might additionally comprise a structuring of the respective deposited conductive layer by lithography, as, e.g., described in Fig. 3.

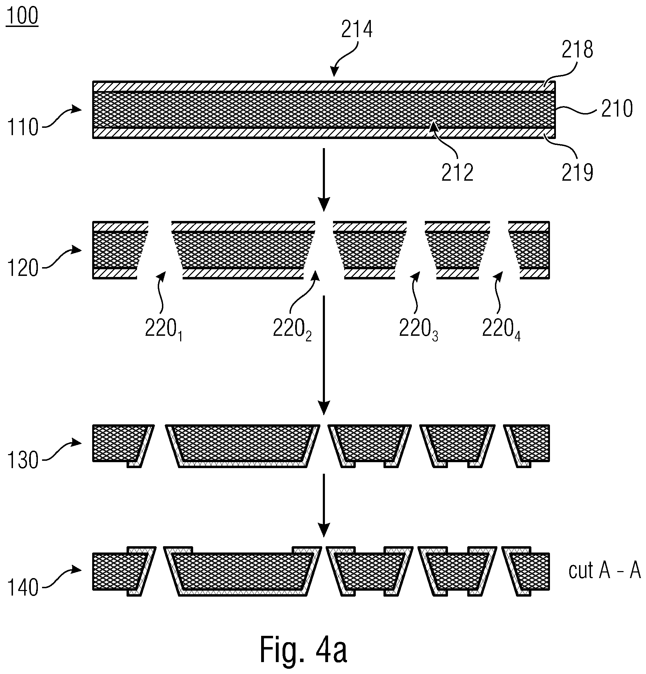

According to an embodiment, the conductive material 232 is deposited 130 on the first main surface region 212 by printing, as, e.g., described with respect to Fig. 4a. Additionally, or alternatively, the further conductive material 242 is deposited 140 on the second main surface region 212 by printing, as, e.g., described with respect to Fig. 4a. In other words, the depositing 130 and/or 140 might be understood as a depositing in a structured manner.

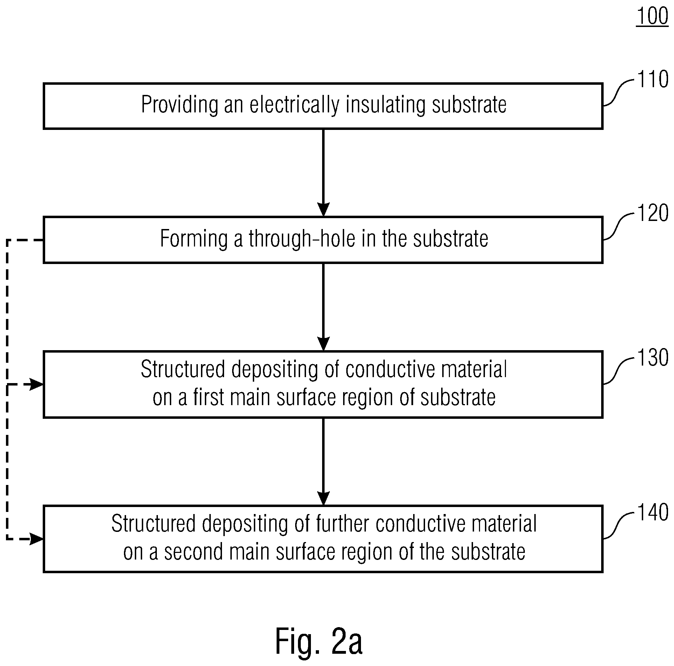

It is to be noted that the method 100 can comprise features and/or functionalities, which are described with regard to the method 100 in Figs. 2a to 5.

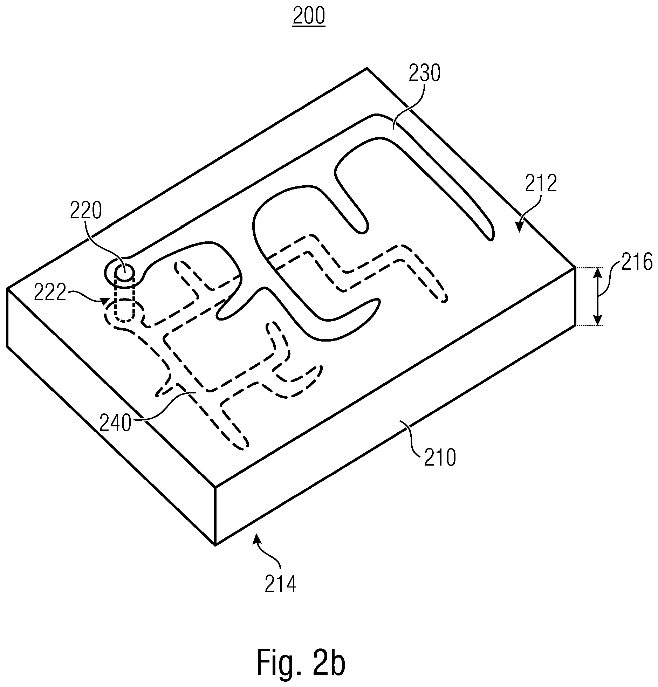

Fig. 2a shows a method 100, e.g., for manufacturing a sheet 200 for double-sided electronics. An example for such a manufactured sheet200 is shown in Fig. 2b.

The method 100 comprises providing 110 and electrically insulating substrate 210, i.e. the substrate 210 is non-conductive. Additionally, the method 100 comprises forming 120 a through-hole 220, e.g., a via, in the substrate 210 between a first 212 and a second 214 main surface region of the substrate 210. The first 212 main surface region, for example, represents a surface of the substrate 210 opposite of the second 214 main surface region of the substrate 210.

The electrically insulating substrate 210, for example, does not comprise any conductive element or layer. No conductive layer, for example, is deposited on the electrically insulating substrate 210 before the forming 120 of the through-hole 220.

Additionally, the method 100 comprises structured depositing 130 of conductive material on the first 212 main surface region of the substrate 210, so that walls 222 of the through-hole 220 are covered by the conductive material and so that first 230 conductive traces are formed on the first 212 main surface region of the substrate 210. It is possible that the complete through-hole 220 is filled with the conductive material at the structured deposition 130. However, it is sufficient to cover the walls 222 of the through-hole 220 with a thin layer of conductive material, e.g., with a thickness between 20 nm and 1 µm. To cover the walls 222 only with the thin layer of the conductive material has the advantage that the through-hole 220 does only marginally influence a flexibility of the manufactured sheet 200 and that the through-hole 220 provides at the same time a good electrical connection between the conductive material on the first 212 and the second 214 main surface region of the substrate 210. Furthermore, the method 100 comprises structured deposition (depositing) 140 of further conductive material on the second 214 main surface region of the substrate 210 so that second 240 conductive traces are formed on the second 14 main surface region of the substrate 210. The structured deposition 130 to provide the first 230 conductive traces on the first 212 main surface region of the substrate 210 might be performed by the method 100 before the structured deposition 140 to provide the second 240 conductive traces on the second 214 main surface region of the substrate 210. Alternatively, the structure deposition 130 and the structured deposition 140 might be performed by the method 100 at the same time.

The inventors found that it is advantageous in terms of efficiency and in terms of increasing an electrical performances and resolution of the manufactured sheet 200, to drill the through-hole, e.g. the via, prior to the deposition, i.e. the structured deposition 130, of the first material, i.e. the conductive material, instead of drilling the via through the substrate 210 with a stop at the already deposited first material. So, an optional cleaning of soot and/or melted polymer at the sidewalls, i.e. the walls 222 of the through-hole 220, is easy and the damage of the first material by the forming120 of the through-hole 220, e.g., using a laser, does not happen. After the opening, i.e. the through-hole 220, in the substrate 210, the following material deposition, i.e. the structured deposition 130 and 140, on both sides, i.e. on the first 212 and the second 214 main surface regions, will cover also the via walls 222 and create a good electrical connection between the two sides. The through-hole 220 electrically connects the first 230 and the second 240 conductive traces. In other words, the structured deposition 130 of the conductive material and the structured deposition 140 of the further conductive material is performed, so that the through-hole 220 provides a conductive connection between the first conductive traces 230 on the first main surface region 212 of the substrate 210 and the second conductive traces 240 on the second main surface region 214 of the substrate 210. The conductive connection, for example, is provided by a layer of the conductive material on the walls 222 of the through hole 220.

According to an embodiment, two or more through-holes 220 are formed in the substrate 210 between the first 212 and the second 214 main surface region of the substrate 210 at the forming 120 of the through-hole 220. The method forms 120 the two or more through-holes instead of only one through-hole. The structured deposition (depositing) 130 of conductive material on the first main surface region 212 of the substrate 210 is performed, so that walls 222 of the two or more through-holes 220 are covered by the conductive material. At least two of the two or more through-holes 220 connect a conductive trace of the first conductive traces with a conductive trace of the second conductive traces by the conductive layer on the walls 222 of the at least two through-holes 220. By using at least two through-holes 220 for an electrical connection between the first 230 and second 240 conductive traces, it is possible to bend the sheet 200 and maintain a good electrical connection between the first 230 and second 240 conductive traces. This is due to the fact that even if the conductive layer in one of the two through-holes 220 breaks at the bending, that there is still an electrical connection through the second through-hole 220 of the at least two through-holes 220. Thus, a very reliable sheet 200 of double-sided conductive traces 230/240 is achieved.

The conductive material for the first 230 conductive traces might be the same material as the further conductive material for the second 240 conductive traces. However, it is also possible that different conductive materials are used for the first 230 conductive traces and the second 240 conductive traces. In other words, the conductive material on the first 212 main surface region of the substrate 210 might differ from the further conductive material on the second 214 main surface region of the substrate 210.

The structured deposition (depositing) 130 and/or the structured deposition (depositing) 140 might be performed by a depositing and subsequent structuring, e.g., as shown in Fig. 3., or by a depositing in a structured manner, e.g., as shown in Fig. 4a. According to an embodiment, both, the structured deposition 130 and the structured deposition 140, might be performed as described with respect to Fig. 3. According to another embodiment, the first 230 conductive traces and the second 240 conductive traces might both be obtained by printing, wherein printing might represent the structure deposition 130/140, as described with respect to Fig. 4a. According to an alternative embodiment, the structured deposition 130 of the conductive material might be performed by a method described with respect to Fig. 3 and the structure deposition 140 of the further conductive material might be performed by printing as, for example, described with respect to Fig. 4a. The other way around is also possible.

According to an embodiment, the substrate 210 comprises a polymer material, ceramic material or glass material. In a preferred embodiment, the substrate 210 comprises a flexible, insulating material, like the polymer material, so that the sheet 200 and/or the substrate 210 have/has at least in some areas a target bending radius between 0,5 mm and 5 mm, 1mm and 5mm, 2mm and 5mm or 0,5mm and 3mm. The target bending radius might depend on the Young's modulus of the substrate material and a thickness 216 of the substrate 210. Optionally, the target bending radius might additionally depend on a thickness of the conductive material on the first 212 main surface region of the substrate 210 and/or on a thickness of the further conductive material on the second 214 main surface region of the substrate 210. However, the target bending radius might only depend on the thickness of the conductive material and/or the further conductive material, if a thick layer, e.g., a layer of at least 5 µm thickness, of the conductive material and/or of the further conductive material is deposited on the respective main surface region 212/214.

According to an embodiment, the substrate 210 has a thickness 216 between 6 µm and 5 mm, 6 µm and 1 mm, 6 µm and 500 µm, like 20 µm, 30 µm, 50 µm, 100 µm, 250 µm or 300 µm.

According to an embodiment, the structured deposition (depositing) 130 of the conductive material on the first 212 main surface region of the substrate 210 is performed so that the first 230 conductive traces have a thickness between 20 nm and 1 µm and the structured deposition (depositing) 140 of the further conductive material on the second 214 main surface region of the substrate 210 is performed so that the second 240 conductive traces have a thickness between 20 nm and 1 µm. Alternatively, the structured deposition 130/140 might be performed so that the thickness of the first 230 conductive traces and/or the second 240 conductive traces might be between 100 nm and 700 nm, 100 nm and 500 nm or 100 nm and 300 nm.

According to an embodiment, the through-hole 220 is formed by cold laser ablation.

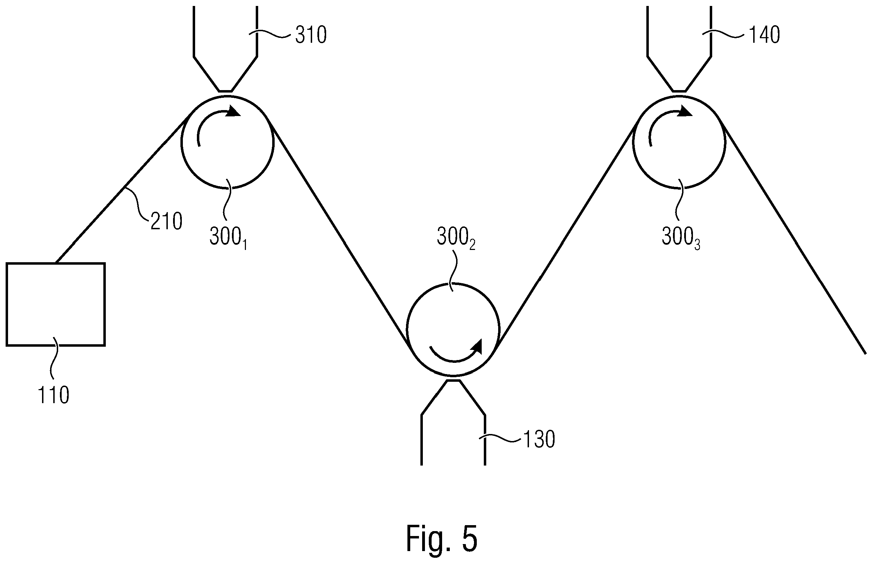

The proposed method has the following advantages:
- No need of a thick layer, it would reduce the wasted material, reduce the manufacturing steps and manufacturing costs
- Allows to work on thin layers and achieve higher electrical performances and resolution
- Independent from the conductive materials on the substrate
- A thicker layer is not mandatory, but only optional if needed
- The entire process can be performed on roll-to-roll (R2R), see e.g. Fig. 5

Optionally, the method 100 can comprise features and/or functionalities as described with respect to the following Figures 3 to 5, like the one or more protective foils 218/219 or the cleaning of the substrate. By using, for example, a protective foil on the back side of the substrate during the via process, i.e. the through-hole forming 120, it is possible to obtain a clean and smooth profile of the through-hole 220

According to an embodiment, the sheet 200, shown in Fig. 1b, represents a circuit board. Optionally, the circuit board might comprise additionally to the first 230 and second 240 conductive traces, which traces are conductively connected by the through-hole, one or more electrical components soldered to the circuit board.

Fig. 3 shows an embodiment of the method 100 with details of the structured deposition 130 and 140.

The method 100 comprises providing 110 an electrically insulating substrate 210. The substrate 210 might comprise a first protective foil 218 adhered to the second 214 main surface region, e.g. the second side, of the substrate 210. Optionally, the substrate 210 might comprise additionally a second protective foil 219 adhered to the first 212 main surface region, e.g. the first side, of the substrate 210. Both protective foils 218/219 are optional to improve a laser profile of the through-holes 220, e.g. the through-holes 220₁, 220₂, 220₃, formed 120 in the substrate 210.

The through-holes 220, e.g., are formed 120 using a laser. The through-holes 220 might be formed beginning at the first 212 main surface region of the substrate 210 and ending at the second 214 main surface region of the substrate 210. At this forming 120 of the through-holes 220, the first protective foil 218 and/or the second protective foil 219 might be destroyed or damaged at the position of the respective through-hole 220. The through-holes 220 might be cone-shaped.

After the forming 120 of the through-holes 220 in the substrate 210, the first protective foil 218 and the second protective foil 219 are removed from the respective main surface region of the substrate 210 to enable a preparation of the first 212 and the second 214 main surface region of the substrate 210 for the structured depositing 130/140.

The preparation of the first 212 and the second 214 main surface region of the substrate 210 might be performed by cleaning the substrate with the through-hole. This cleaning is performed before the structured deposition (depositing) 130 of the conductive material on the first 212 main surface region, e.g. the first side, of the substrate 210 and the structured deposition (depositing) 140 of the further conductive material on the second 214 main surface region of the substrate 210. The cleaning of the substrate might be performed using an ultrasonic bath and/or using plasma surface cleaning. The cleaning reduces, for example, a pollution by soot and/or melted polymer of ablated substrate around the through-hole.

As shown in Fig. 3, the structured deposition (depositing) 130 of the conductive material on the first 212 main surface region of the substrate 210 can be performed by depositing 132 the conductive material on the first 212 main surface region of the substrate 210 to cover the entire first 212 main surface region of the substrate 210 and the walls 222 of the through-holes 220 with a layer 133 of the conductive material, and by structuring 134 the layer 133 of the conductive material to form the first conductive traces 230 using the through-hole 220, i.e. the through-holes 220₁, 220₂, 220₃, in the substrate 210 as reference for alignment of the first conductive traces 230.

The structured deposition (depositing) 140 of the further conductive material on the second 214 main surface region of the substrate 210 is performed by depositing 142 the further conductive material on the second 214 main surface region of the substrate 210 to cover the entire second 214 main surface region of the substrate 210 with a layer 143 of the further conductive material, and by structuring 144 the layer 143 of the further conductive material to form the second 240 conductive traces using the through-hole 220, i.e. the through-holes 220₁, 220₂, 220₃, in the substrate 210 as reference for alignment of the second 240 conductive traces.

The depositing 132 and/or 142 might be performed by sputtering or evaporation. It is possible, that the layer 133 and the layer 143 are deposited 132/142 by sputtering, or that the layer 133 and the layer 143 are deposited 132/142 by evaporation. Alternatively, both methods, i.e. sputtering and evaporation, are used, wherein one layer is deposited by sputtering and the other is deposited by evaporation.

Both layers 133 and 143, for example, are structured 134/144 by lithography. To structure 134/144 the layer 133 and the layer 143, the method 100 comprises
- laminating 134₁ a dry film photoresist onto the layer 133 of conductive material to form a first layer 152 of photoresist, so that the conductive material on the walls 222 of the through-holes 220 is protected by the dry film photoresist, and at the same time, or after the laminating 144₁, laminating 150₂ a further dry film photoresist, e.g. the same as for the first layer 152 of photoresist, onto the layer 143 of further conductive material to form a second layer 154 of photoresist,
   e.g., in case of using a fluid photoresist, the fluid photoresist is applied to the layer 133 of conductive material to form the first layer 152 of photoresist, so that the conductive material on the walls 222 of the through-holes 220 is covered by the fluid photoresist, and a further fluid photoresist, e.g. the same as for the first layer 152 of photoresist, is applied onto the layer 143 of further conductive material to form the second layer 154 of photoresist;
- expose 144₂ areas 154a of the second layer 154 of photoresist to light using the through-holes 220 as reference for alignment, wherein the photoresist protecting the conductive walls of the through-holes 220 is not exposed to the light.
- expose 134₂ areas 152a of the first layer 152 of photoresist to the light using the through-holes 220 as reference for alignment,
- developing 134₃/144₃ at the same time the first layer 152 of photoresist and the second layer 154 of photoresist,
- etching 134₄/144₄ at the same time the layer 133 of conductive material and the layer 143 of further conductive material at the exposed areas 152a and 154a, e.g., utilizing the substrate 210 as etch stop, and
- stripping 134₅/144₅ at the same time the first layer 152 of photoresist from the layer 133 of conductive material and the second layer 154 of photoresist from the layer 143 of further conductive material.

The structured deposition 130 of the conductive material on the first 212 main surface region of the substrate 210, for example, comprises the aforementioned steps 132 and 134₁ to 134₅. The structured deposition 130 is performed so that walls 222 of the through-holes 220 are covered by the conductive material and so that the first 230 conductive traces are formed on the first 212 main surface region of the substrate 210.

The structured deposition 140 of the further conductive material on the second 214 main surface region of the substrate 210, for example, comprises the aforementioned steps 142 and 144₁ to 144₅. The structured deposition 140 is performed so that the second 240 conductive traces are formed on the second 214 main surface region of the substrate 210.

In other words, the method 100 might comprise the following steps:
1. Through-holes forming 120, e.g., drilling, on the substrate 210 by cold laser ablation, it is a digital process and it can be used to obtain a continuous reference layer (for quasi-endless structure) or for independent samples. It can be used for sheet-to-sheet, roll-to-sheet and roll-to-roll manufacturing steps. The first protective foil 218, for example, is on the opposite side, i.e. the second 214 main surface region, of the laser ablation side, i.e. the first 212 main surface region. The through-holes 220 can be used as vias for electrical connections between the two sides of the substrate 210 and as alignment marks for subsequent layers or structuring
2. Removing of the one or more protective foils 218/219 if one or more protective foils 218/219 are adhered to the substrate 210.
3. Optionally, substrate washing, e.g., with an ultrasonic bath and/or plasma surface cleaning to remove debris around the vias, i.e. the through-holes 220
4. Conductive material deposition on both side of the substrate, i.e. the structured deposition 130/140:
   a. It can be performed by sputtering or evaporation, wherein the entire substrate 210 will be covered by the conductive material, as shown in Fig. 3
   b. It can be performed by printing using, for example, the through-holes 220 in the substrate 210 as reference layer for alignment, as shown in Fig. 4a
   c. It can be a combination of two different technologies, one for each side of the substrate 210
5. In case of printing, as shown in Fig. 4a, the structure, e.g. of the first 230 and the second 240 conductive traces, is defined by the layout and further structuring steps are not necessary
6. In case of the other deposition method that covers the entire substrate, e.g. the sputtering or evaporation, the structuring can be performed on both sides, i.e. the first 212 and the second 214 main surface region, and some steps can be combined. For example in case of sputtering or evaporation and subsequent structuring by lithography the process flow might be the following:
   a. Sputtering or evaporating Side 1, e.g. performing the depositing 132 on the first 212 main surface region
   b. Sputtering or evaporating Side 2, e.g. performing the depositing 142 on the second 214 main surface region
   c. Dry film photoresist lamination Side 1, e.g. the laminating 134₁
   d. Dry film photoresist lamination Side 2, e.g. laminating 144₁
   e. Exposure 134₂ side 1 (using holes as reference layer)
   f. Exposure 144₂ side 2 (using holes as reference layer)
   g. Development 134₃/144₃ Side 1 + Side 2
   h. Etching 134₄/144₄ Side 1 + Side 2
   i. Stripping 134₅/144₅ Side 1 + Side 2

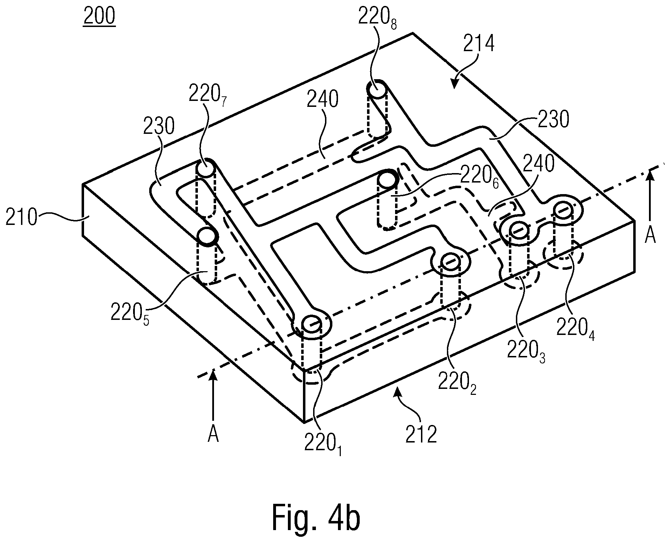

Fig. 4a shows a method 100 in which the structured depositing 130 and 140 is performed by printing and Fig. 4b shows schematically a sheet 200 manufactured by the method shown in Fig. 4a. The manufactured sheet 200 can be used for double sided electronics.

The method 100 comprises providing 110 an electrically insulating substrate 210. The substrate 210 might comprise on the first 212 and the second 214 main surface region of the substrate 210 a protective foil 218/219. A first protective foil 218 is adhered to the second 214 main surface region of the substrate and a second protective foil 219 is adhered to the first 212 main surface region of the substrate 210. Alternatively, it is also possible, that only one of the two protective foils is adhered to one of the main surface regions 212/214 of the substrate 210 or that no protective foil is adhered to the substrate 210, as, e.g., shown in Fig.2a.

Additionally, the method 100 comprises forming 120 through-holes 220, e.g., the through-holes 220₁ to 220₈ in the substrate 210 between the first 212 and the second 214 main surface region of the substrate 210.

After the forming 120 of the through-holes 220 in the substrate 210, the first protective foil 218 and the second protective foil 219 are removed from the respective main surface region of the substrate 210 to enable a preparation of the first 212 and the second 214 main surface region of the substrate 210 for the structured deposition 130/140. The preparation of the first 212 and the second 214 main surface region of the substrate 210 might be performed by cleaning the substrate 210 with the through-holes 220. This cleaning might be performed as described with respect to Fig. 3.

Additionally, the method 100 comprises a structured deposition (depositing) 130 of conductive material on the first 212 main surface region of the substrate 210 by printing, e.g., screen printing. At the printing, i.e. the structured deposition 130, the through-holes 220 in the substrate 210 are used as reference for alignment of first 230 conductive traces on the first 212 main surface region of the substrate 210.

The method comprises further a structured deposition (depositing) 140 of further conductive material on the second 214 main surface region of the substrate 210 by printing, e.g., screen printing. At the printing, i.e. the structured deposition 140, the through-holes 220 in the substrate 210 are used as reference for alignment of second 240 conductive traces on the second 214 main surface region of the substrate 210.

The through-holes 220 are electrically connecting the first 230 and the second 240 conductive traces.

According to an embodiment, the sheet 200, shown in Fig. 4b, represents a circuit board. Optionally, the circuit board might comprise additionally to the first 230 and second 240 conductive traces, which traces are conductively connected by the through-hole, one or more electrical components soldered to the circuit board.

According to an embodiment, the aforementioned methods 100 can be part of a sheet-to-sheet-process, a roll-to-sheet-process or a roll-to-roll-process.

Fig. 5 shows exemplarily the method 100 of Fig. 2a in a roll-to-roll process.

At first, an electrically insulating substrate 210 is provided 110 and transported to a first roll 300₁, where one or more through-holes are formed, e.g. using a laser 310. The substrate 210 with the one or more through-holes is transported to a further roll 300₂. At this further roll 300₂ the method performs the structured depositing of conductive material on the first main surface region of the substrate, so that walls of the through-hole are covered by the conductive material and so that first conductive traces are formed on the first main surface region of the substrate. The substrate is transported to an even further roll 300₃. At this even further roll, 300₃ the method performs the structured depositing of further conductive material on the second main surface region of the substrate so that second conductive traces are formed on the second main surface region of the substrate.

By being able to perform the herein described methods in a roll-to-roll process, it is possible to manufacture many sheets 200 very efficiently. The developed full roll-to-roll quasi-endless manufacturing process with through-substrate vias, e.g. the through-holes, on flexible substrates enables high resolution double-sided electronics on thin layers.

Although, Fig. 5 shows only the steps described with respect to Fig. 2a, it is clear that the steps described with respect to Fig. 1a and/or Fig. 3 and/or Fig. 4a might be applicable in a roll-to-roll process, like the removing of the one or more protective foils and the cleaning of the substrate. Furthermore, it is clear that Fig. 5 shows only schematically the structured deposition 130 and 140 and it is clear, that in case of the structured deposition 130/140 being performed as described with respect to Fig. 3, that the all the steps shown for such a depositing can be implemented in a roll-to-roll process. Additional rolls might be provided for the further steps described in Fig. 3 and Fig. 4a. It is also clear, that the structured deposition 130 and 140 shown in Fig. 5 might be replaced by a depositing 130 and 140, as described with respect to Fig. 1a.

Additionally, it is to be noted that the herein described sheets 200 might represent foils or hard plates. Whether the sheet 200 is a foil or a hard plate, depends on the material of the substrate of the sheet 200.

Although some aspects have been described in the context of product, it is clear that these aspects also represent a description of the corresponding method, where a method step or a feature of a method step results in the feature of the product. Analogously, aspects described in the context of a method step also represent a description of a corresponding feature of a corresponding product.

Generally, embodiments of the present invention can be implemented as a computer program product with a program code, the program code being operative for performing one of the methods when the computer program product runs on a computer. The program code may for example be stored on a machine readable carrier.

## Claims

1. Method (100), comprising
providing (110) an electrically insulating substrate (210), wherein the substrate (210) comprises a flexible, insulating material, and wherein the substrate (210) comprises a first protective foil (218) adhered to a second main surface region (214) of the substrate (210);
forming (120) a through-hole (220; 220₁-220₈) in the substrate (210) between a first (212) and the second (214) main surface region of the substrate (210),
removing the first protective foil (218) from the second main surface region (214) of the substrate (210) after the forming (120) of the through-hole (220; 220₁-220₈) in the substrate (210);
depositing (130) conductive material on the first main surface region (212) of the substrate (210), so that walls (222) of the through-hole (220; 220₁-220₈) are covered by the conductive material and structuring the deposited conductive material to form first conductive traces (230) on the first main surface region (212) of the substrate (210); and
depositing (140) further conductive material on the second main surface region (214) of the substrate (210) and structuring the deposited further conductive material to form second conductive traces (240) on the second main surface region (214) of the substrate (210);
wherein the method (100) is part of a sheet-to-sheet-process, a roll-to-sheet-process or a roll-to-roll-process.

2. Method (100) according to claim 1, wherein the substrate(210) has at least in some areas a target bending radius between 0,5 mm and 5 mm.

3. Method (100) according to claim 1 or claim 2, wherein the through-hole (220; 220₁-220₈) is formed by cold laser ablation.

4. Method (100) according to claims 1 to 3, wherein the substrate (210) comprises a second protective foil (219) adhered to the first main surface region (212) of the substrate (210) and
wherein the method (100) additionally, comprises removing the second protective foil (219) from the first main surface region (212) of the substrate (210) after the forming (120) of the through-hole (220; 220₁-220₈) in the substrate (210).

5. Method (100) according to one of the aforementioned claims,
wherein the depositing (130) and the structuring of the conductive material on the first main surface region (212) of the substrate represents a structured depositing, so that the first conductive traces (230) are formed on the first main surface region (212) of the substrate (210); and
wherein the depositing (140) and the structuring of the further conductive material on the second main surface region (214) of the substrate represents a structured depositing, so that the second conductive traces (240) are formed on the second main surface region (214) of the substrate (210).

6. Method (100) according to claim 5,
wherein the structured depositing (130) of the conductive material on the first main surface region (212) of the substrate (210) is performed so that the first conductive traces (230) have a thickness between 20 nm and 1 µm and
wherein the structured depositing (140) of the further conductive material on the second main surface region (214) of the substrate (210) is performed so that the second conductive traces (240) have a thickness between 20 nm and 1 µm.

7. Method (100) according to claim 5 or claim 6, wherein the method (100) comprises cleaning the substrate (210) with the through-hole (220; 220₁-220₈) before the structured depositing (130) of the conductive material on the first main surface region (212) of the substrate (210) and the structured depositing (140) of the further conductive material on the second main surface region (214) of the substrate (210).

8. Method (100) according to claim 7, wherein the cleaning of the substrate (210) with the through-hole (220; 220₁-220₈) is performed using an ultrasonic bath and/or using plasma surface cleaning.

9. Method (100) according to one of claims 5 to 8,
wherein the structured depositing (130) of the conductive material on the first main surface region (212) of the substrate (210) is performed by printing using the through-hole (220; 220₁-220₈) in the substrate (210) as reference for alignment of the first conductive traces (230); and/or
the structured depositing (140) of the further conductive material on the second main surface region (214) of the substrate (210) is performed by printing using the through-hole (220; 220₁-220₈) in the substrate (210) as reference for alignment of the second conductive traces (240).

10. Method (100) according to one of claims 5 to 9,
wherein the structured depositing (130) of the conductive material on the first main surface region (212) of the substrate (210) is performed by
depositing (132) the conductive material on the first main surface region (212) of the substrate (210) to cover the entire first main surface region (212) of the substrate (210) with a layer (133) of the conductive material and structuring (134, 134₁-134₅) the layer (133) of the conductive material to form the first conductive traces (230) using the through-hole (220; 220₁-220₈) in the substrate (210) as reference for alignment of the first conductive traces (230);
and/or
wherein the structured depositing (140) of the further conductive material on the second main surface region (214) of the substrate (210) is performed by
depositing (142) the further conductive material on the second main surface region (214) of the substrate (210) to cover the entire second main surface region (214) of the substrate (210) with a layer (143) of the further conductive material and
structuring (144, 144₁-144₅) the layer (143) of the further conductive material to form the second conductive traces (240) using the through-hole (220; 220₁-220₈) in the substrate (210) as reference for alignment of the second conductive traces (240).

11. Method (100) according to claim 10,
wherein the depositing (132) of the conductive material on the first main surface region (212) of the substrate (210) to form the layer (133) of the conductive material is performed by sputtering or evaporation;
and/or
wherein the depositing (142) of the further conductive material on the second main surface region (214) of the substrate (210) to form the layer (143) of the further conductive material is performed by sputtering or evaporation.

12. Method (100) according to claim 10 or claim 11,
wherein the structuring (134, 134₁-134₅) of the layer (133) of the conductive material is performed by lithography;
and/or
wherein the structuring (144, 144₁-144₅) of the layer (143) of the further conductive material is performed by lithography.

13. Method (100) according to one of claims 5 to 12,
wherein two or more through-holes (220; 220₁-220₈) are formed in the substrate (210) between the first (212) and the second (214) main surface region of the substrate (210) at the forming (120) of the through-hole (220; 220₁-220₈); and
wherein the structured depositing (130) of conductive material on the first main surface region (212) of the substrate (210) is performed, so that walls (222) of the two or more through-holes (220; 220₁-220₈) are covered by the conductive material.

14. Method (100), comprising
providing (110) an electrically insulating substrate (210), wherein the substrate (210) comprises a flexible, insulating material, and wherein the substrate (210) comprises a first protective foil (218) adhered to a second main surface region (214) of the substrate (210);
forming (120) a through-hole (220; 220₁-220₈) in the substrate (210) between a first (212) and a second (214) main surface region of the substrate (210),
removing the first protective foil (218) from the second main surface region (214) of the substrate (210) after the forming (120) of the through-hole (220; 220₁-220₈) in the substrate (210);
structured depositing (130) of conductive material on the first main surface region (212) of the substrate (210), so that walls (222) of the through-hole (220; 220₁-220₈) are covered by the conductive material and so that first conductive traces (230) are formed on the first main surface region (212) of the substrate (210); and
structured depositing (140) of further conductive material on the second main surface region (214) of the substrate (210) so that second conductive traces (240) are formed on the second main surface region (214) of the substrate (210);
wherein the structured depositing (130) of the conductive material on the first main surface region (212) of the substrate (210) is performed by printing using the through-hole (220; 220₁-220₈) in the substrate (210) as reference for alignment of the first conductive traces (230); and/or
the structured depositing (140) of the further conductive material on the second main surface region (214) of the substrate (210) is performed by printing using the through-hole (220; 220₁-220₈) in the substrate (210) as reference for alignment of the second conductive traces (240).

15. Method (100), comprising
providing (110) an electrically insulating substrate (210) , wherein the substrate (210) comprises a flexible, insulating material,and wherein the substrate (210) comprises a first protective foil (218) adhered to a second main surface region (214) of the substrate (210);
forming (120) a through-hole (220; 220₁-220₈) in the substrate (210) between a first (212) and a second (214) main surface region of the substrate (210),
removing the first protective foil (218) from the second main surface region (214) of the substrate (210) after the forming (120) of the through-hole (220; 220₁-220₈) in the substrate (210);
structured depositing (130) of conductive material on the first main surface region (212) of the substrate (210), so that walls (222) of the through-hole (220; 220₁-220₈) are covered by the conductive material and so that first conductive traces (230) are formed on the first main surface region (212) of the substrate (210); and structured depositing (140) of further conductive material on the second main surface region (214) of the substrate (210) so that second conductive traces (240) are formed on the second main surface region (214) of the substrate (210);
wherein the structured depositing (130) of the conductive material on the first main surface region (212) of the substrate (210) is performed by
depositing (132) the conductive material on the first main surface region (212) of the substrate (210) to cover the entire first main surface region (212) of the substrate (210) with a layer (133) of the conductive material and structuring (134, 134₁-134₅) the layer (133) of the conductive material to form the first conductive traces (230) using the through-hole (220; 220₁-220₈) in the substrate (210) as reference for alignment of the first conductive traces (230);
and/or
wherein the structured depositing (140) of the further conductive material on the second main surface region (214) of the substrate (210) is performed by
depositing (142) the further conductive material on the second main surface region (214) of the substrate (210) to cover the entire second main surface region (214) of the substrate (210) with a layer (143) of the further conductive material and
structuring (144, 144₁-144₅) the layer (143) of the further conductive material to form the second conductive traces (240) using the through-hole (220; 220₁-220₈) in the substrate (210) as reference for alignment of the second conductive traces (240).

## Patentansprüche

1. Verfahren (100), das folgende Schritte aufweist:
Bereitstellen (110) eines elektrisch isolierenden Substrats (210), wobei das Substrat (210) ein flexibles, isolierendes Material aufweist, und wobei das Substrat (210) eine erste Schutzfolie (218) aufweist, die an einem zweiten Hauptoberflächenbereich (214) des Substrats (210) haftet;
Bilden (120) eines Durchgangslochs (220; 220₁-220₈) in dem Substrat (210) zwischen einem ersten (212) und dem zweiten (214) Hauptoberflächenbereich des Substrats (210),
Entfernen der ersten Schutzfolie (218) von dem zweiten Hauptoberflächenbereich (214) des Substrats (210) nach dem Bilden (120) des Durchgangslochs (220; 220₁-220₈) in dem Substrat (210);
Abscheiden (130) von leitfähigem Material auf dem ersten Hauptoberflächenbereich (212) des Substrats (210), so dass Wände (222) des Durchgangslochs (220; 220₁-220₈) durch das leitfähige Material bedeckt sind, und Strukturieren des abgeschiedenen leitfähigen Materials, um erste Leiterbahnen (230) auf dem ersten Hauptoberflächenbereich (212) des Substrats (210) zu bilden; und
Abscheiden (140) von weiterem leitfähigem Material auf dem zweiten Hauptoberflächenbereich (214) des Substrats (210) und Strukturieren des abgeschiedenen weiteren leitfähigen Materials, um zweite Leiterbahnen (240) auf dem zweiten Hauptoberflächenbereich (214) des Substrats (210) zu bilden;
wobei das Verfahren (100) Teil eines Bogen-zu-Bogen-Prozesses, eines Rolle-zu-Bogen-Prozesses oder eines Rolle-zu-Rolle-Prozesses ist.

2. Verfahren (100) gemäß Anspruch 1, bei dem das Substrat (210) zumindest in einigen Bereichen einen Zielbiegeradius zwischen 0,5 mm und 5 mm aufweist.

3. Verfahren (100) gemäß Anspruch 1 oder Anspruch 2, bei dem das Durchgangsloch (220; 220₁-220₈) durch Kaltlaserablation gebildet wird.

4. Verfahren (100) gemäß den Ansprüchen 1 bis 3, bei dem das Substrat (210) eine zweite Schutzfolie (219) aufweist, die an dem ersten Hauptoberflächenbereich (212) des Substrats (210) haftet, und
wobei das Verfahren (100) zusätzlich ein Entfernen der zweiten Schutzfolie (219) von dem ersten Hauptoberflächenbereich (212) des Substrats (210) nach dem Bilden (120) des Durchgangslochs (220; 220₁-220₈) in dem Substrat (210) aufweist.

5. Verfahren (100) gemäß einem der oben genannten Ansprüche,
bei dem das Abscheiden (130) und das Strukturieren des leitfähigen Materials auf dem ersten Hauptoberflächenbereich (212) des Substrats ein strukturiertes Abscheiden darstellt, so dass die ersten Leiterbahnen (230) auf dem ersten Hauptoberflächenbereich (212) des Substrats (210) gebildet werden; und
bei dem das Abscheiden (140) und das Strukturieren des weiteren leitfähigen Materials auf dem zweiten Hauptoberflächenbereich (214) des Substrats ein strukturiertes Abscheiden darstellt, so dass die zweiten Leiterbahnen (240) auf dem zweiten Hauptoberflächenbereich (214) des Substrats (210) gebildet werden.

6. Verfahren (100) gemäß Anspruch 5,
bei dem das strukturierte Abscheiden (130) des leitfähigen Materials auf dem ersten Hauptoberflächenbereich (212) des Substrats (210) so durchgeführt wird, dass die ersten Leiterbahnen (230) eine Dicke zwischen 20 nm und 1 µm aufweisen, und
bei dem das strukturierte Abscheiden (140) des weiteren leitfähigen Materials auf dem zweiten Hauptoberflächenbereich (214) des Substrats (210) so durchgeführt wird, dass die zweiten Leiterbahnen (240) eine Dicke zwischen 20 nm und 1 µm aufweisen.

7. Verfahren (100) gemäß Anspruch 5 oder Anspruch 6, wobei das Verfahren (100) ein Reinigen des Substrats (210) mit dem Durchgangsloch (220; 220₁-220₈) vor dem strukturierten Abscheiden (130) des leitfähigen Materials auf dem ersten Hauptoberflächenbereich (212) des Substrats (210) und dem strukturierten Abscheiden (140) des weiteren leitfähigen Materials auf dem zweiten Hauptoberflächenbereich (214) des Substrats (210) aufweist.

8. Verfahren (100) gemäß Anspruch 7, bei dem das Reinigen des Substrats (210) mit dem Durchgangsloch (220; 220₁-220₈) unter Verwendung eines Ultraschallbads und/oder unter Verwendung einer Plasmaoberflächenreinigung durchgeführt wird.

9. Verfahren (100) gemäß einem der Ansprüche 5 bis 8,
bei dem das strukturierte Abscheiden (130) des leitfähigen Materials auf dem ersten Hauptoberflächenbereich (212) des Substrats (210) durch Drucken unter Verwendung des Durchgangslochs (220; 220₁-220₈) in dem Substrat (210) als Referenz für eine Ausrichtung der ersten Leiterbahnen (230) durchgeführt wird; und/oder
das strukturierte Abscheiden (140) des weiteren leitfähigen Materials auf dem zweiten Hauptoberflächenbereich (214) des Substrats (210) durch Drucken unter Verwendung des Durchgangslochs (220; 220₁-220₈) in dem Substrat (210) als Referenz für eine Ausrichtung der zweiten Leiterbahnen (240) durchgeführt wird.

10. Verfahren (100) gemäß einem der Ansprüche 5 bis 9,
bei dem das strukturierte Abscheiden (130) des leitfähigen Materials auf dem ersten Hauptoberflächenbereich (212) des Substrats (210) durchgeführt wird durch
Abscheiden (132) des leitfähigen Materials auf dem ersten Hauptoberflächenbereich (212) des Substrats (210), um den gesamten ersten Hauptoberflächenbereich (212) des Substrats (210) mit einer Schicht (133) des leitfähigen Materials zu bedecken, und
Strukturieren (134, 134₁-134₅) der Schicht (133) des leitfähigen Materials, um die ersten Leiterbahnen (230) unter Verwendung des Durchgangslochs (220; 220₁-220₈) in dem Substrat (210) als Referenz für eine Ausrichtung der ersten Leiterbahnen (230) zu bilden;
und/oder
bei dem das strukturierte Abscheiden (140) des weiteren leitfähigen Materials auf dem zweiten Hauptoberflächenbereich (214) des Substrats (210) durchgeführt wird durch
Abscheiden (142) des weiteren leitfähigen Materials auf dem zweiten Hauptoberflächenbereich (214) des Substrats (210), um den gesamten zweiten Hauptoberflächenbereich (214) des Substrats (210) mit einer Schicht (143) des weiteren leitfähigen Materials zu bedecken, und
Strukturieren (144, 144₁-144₅) der Schicht (143) des weiteren leitfähigen Materials, um die zweiten Leiterbahnen (240) unter Verwendung des Durchgangslochs (220; 220₁-220₈) in dem Substrat (210) als Referenz für eine Ausrichtung der zweiten Leiterbahnen (240) zu bilden.

11. Verfahren (100) gemäß Anspruch 10,
bei dem das Abscheiden (132) des leitfähigen Materials auf dem ersten Hauptoberflächenbereich (212) des Substrats (210), um die Schicht (133) des leitfähigen Materials zu bilden, durch Sputtern oder Verdampfen durchgeführt wird;
und/oder
bei dem das Abscheiden (142) des weiteren leitfähigen Materials auf dem zweiten Hauptoberflächenbereich (214) des Substrats (210), um die Schicht (143) des weiteren leitfähigen Materials zu bilden, durch Sputtern oder Verdampfen durchgeführt wird.

12. Verfahren (100) gemäß Anspruch 10 oder Anspruch 11,
bei dem das Strukturieren (134, 134₁-134₅) der Schicht (133) des leitfähigen Materials durch Lithographie durchgeführt wird;
und/oder
bei dem das Strukturieren (144, 144₁-144₅) der Schicht (143) des weiteren leitfähigen Materials durch Lithographie durchgeführt wird.

13. Verfahren (100) gemäß einem der Ansprüche 5 bis 12,
bei dem zwei oder mehr Durchgangslöcher (220; 220₁-220₈) in dem Substrat (210) zwischen dem ersten (212) und dem zweiten (214) Hauptoberflächenbereich des Substrats (210) bei dem Bilden (120) des Durchgangslochs (220; 220₁-220₈) gebildet werden; und
bei dem das strukturierte Abscheiden (130) von leitfähigem Material auf dem ersten Hauptoberflächenbereich (212) des Substrats (210) durchgeführt wird, so dass Wände (222) der zwei oder mehr Durchgangslöcher (220; 220₁-220₈) durch das leitfähige Material bedeckt sind.

14. Verfahren (100), das folgende Schritte aufweist:
Bereitstellen (110) eines elektrisch isolierenden Substrats (210), wobei das Substrat (210) ein flexibles, isolierendes Material aufweist, und wobei das Substrat (210) eine erste Schutzfolie (218) aufweist, die an einem zweiten Hauptoberflächenbereich (214) des Substrats (210) haftet;
Bilden (120) eines Durchgangslochs (220; 220₁-220₈) in dem Substrat (210) zwischen einem ersten (212) und einem zweiten (214) Hauptoberflächenbereich des Substrats (210),
Entfernen der ersten Schutzfolie (218) von dem zweiten Hauptoberflächenbereich (214) des Substrats (210) nach dem Bilden (120) des Durchgangslochs (220; 220₁-220₈) in dem Substrat (210);
strukturiertes Abscheiden (130) von leitfähigem Material auf dem ersten Hauptoberflächenbereich (212) des Substrats (210), so dass Wände (222) des Durchgangslochs (220; 220₁-220₈) durch das leitfähige Material bedeckt sind, und so dass erste Leiterbahnen (230) auf dem ersten Hauptoberflächenbereich (212) des Substrats (210) gebildet werden; und
strukturiertes Abscheiden (140) von weiterem leitfähigem Material auf dem zweiten Hauptoberflächenbereich (214) des Substrats (210), so dass zweite Leiterbahnen (240) auf dem zweiten Hauptoberflächenbereich (214) des Substrats (210) gebildet werden;
bei dem das strukturierte Abscheiden (130) des leitfähigen Materials auf dem ersten Hauptoberflächenbereich (212) des Substrats (210) durch Drucken unter Verwendung des Durchgangslochs (220; 220₁-220₈) in dem Substrat (210) als Referenz für eine Ausrichtung der ersten Leiterbahnen (230) durchgeführt wird; und/oder
das strukturierte Abscheiden (140) des weiteren leitfähigen Materials auf dem zweiten Hauptoberflächenbereich (214) des Substrats (210) durch Drucken unter Verwendung des Durchgangslochs (220; 220₁-220₈) in dem Substrat (210) als Referenz für eine Ausrichtung der zweiten Leiterbahnen (240) durchgeführt wird.

15. Verfahren (100), das folgende Schritte aufweist:
Bereitstellen (110) eines elektrisch isolierenden Substrats (210), wobei das Substrat (210) ein flexibles, isolierendes Material aufweist, und wobei das Substrat (210) eine erste Schutzfolie (218) aufweist, die an einem zweiten Hauptoberflächenbereich (214) des Substrats (210) haftet;
Bilden (120) eines Durchgangslochs (220; 220₁-220₈) in dem Substrat (210) zwischen einem ersten (212) und einem zweiten (214) Hauptoberflächenbereich des Substrats (210),
Entfernen der ersten Schutzfolie (218) von dem zweiten Hauptoberflächenbereich (214) des Substrats (210) nach dem Bilden (120) des Durchgangslochs (220; 220₁-220₈) in dem Substrat (210);
strukturiertes Abscheiden (130) von leitfähigem Material auf dem ersten Hauptoberflächenbereich (212) des Substrats (210), so dass Wände (222) des Durchgangslochs (220; 220₁-220₈) durch das leitfähige Material bedeckt sind, und so dass erste Leiterbahnen (230) auf dem ersten Hauptoberflächenbereich (212) des Substrats (210) gebildet werden; und
strukturiertes Abscheiden (140) von weiterem leitfähigem Material auf dem zweiten Hauptoberflächenbereich (214) des Substrats (210), so dass zweite Leiterbahnen (240) auf dem zweiten Hauptoberflächenbereich (214) des Substrats (210) gebildet werden;
bei dem das strukturierte Abscheiden (130) des leitfähigen Materials auf dem ersten Hauptoberflächenbereich (212) des Substrats (210) durchgeführt wird durch
Abscheiden (132) des leitfähigen Materials auf dem ersten Hauptoberflächenbereich (212) des Substrats (210), um den gesamten ersten Hauptoberflächenbereich (212) des Substrats (210) mit einer Schicht (133) des leitfähigen Materials zu bedecken, und
Strukturieren (134, 134₁-134₅) der Schicht (133) des leitfähigen Materials, um die ersten Leiterbahnen (230) unter Verwendung des Durchgangslochs (220; 220₁-220₈) in dem Substrat (210) als Referenz für eine Ausrichtung der ersten Leiterbahnen (230) zu bilden;
und/oder
bei dem das strukturierte Abscheiden (140) des weiteren leitfähigen Materials auf dem zweiten Hauptoberflächenbereich (214) des Substrats (210) durchgeführt wird durch
Abscheiden (142) des weiteren leitfähigen Materials auf dem zweiten Hauptoberflächenbereich (214) des Substrats (210), um den gesamten zweiten Hauptoberflächenbereich (214) des Substrats (210) mit einer Schicht (143) des weiteren leitfähigen Materials zu bedecken, und
Strukturieren (144, 144₁-144₅) der Schicht (143) des weiteren leitfähigen Materials, um die zweiten Leiterbahnen (240) unter Verwendung des Durchgangslochs (220; 220₁-220₈) in dem Substrat (210) als Referenz für eine Ausrichtung der zweiten Leiterbahnen (240) zu bilden.

## Revendications

1. Procédé (100), comprenant
la fourniture (110) d'un substrat électriquement isolant (210), dans lequel le substrat (210) comprend un matériau isolant souple, et dans lequel le substrat (210) comprend une première feuille de protection (218) collée sur une deuxième région de surface principale (214) du substrat (210) ;
la formation (120) d'un trou traversant (220 ; 220₁-220₈) dans le substrat (210) entre une première (212) et la deuxième (214) région de surface principale du substrat (210),
l'enlèvement de la première feuille de protection (218) de la deuxième région de surface principale (214) du substrat (210) après la formation (120) du trou traversant (220 ; 220₁-220₈) dans le substrat (210) ;
le dépôt (130) de matériau conducteur sur la première région de surface principale (212) du substrat (210), de sorte que les parois (222) du trou traversant (220 ; 220₁-220₈) soient recouvertes par le matériau conducteur et la structuration du matériau conducteur déposé pour former des premières pistes conductrices (230) sur la première région de surface principale (212) du substrat (210) ; et
le dépôt (140) de matériau conducteur supplémentaire sur la deuxième région de surface principale (214) du substrat (210) et la structuration du matériau conducteur supplémentaire déposé pour former des deuxièmes pistes conductrices (240) sur la deuxième région de surface principale (214) du substrat (210) ;
dans lequel le procédé (100) fait partie d'un procédé feuille à feuille, d'un procédé rouleau à feuille ou d'un procédé rouleau à rouleau.

2. Procédé (100) selon la revendication 1, dans lequel le substrat (210) présente, au moins dans certaines zones, un rayon de courbure cible compris entre 0,5 mm et 5 mm.

3. Procédé (100) selon la revendication 1 ou la revendication 2, dans lequel le trou traversant (220 ; 220₁-220₈) est formé par ablation au laser à froid.

4. Procédé (100) selon les revendications 1 à 3, dans lequel le substrat (210) comprend une deuxième feuille de protection (219) collée à la première région de surface principale (212) du substrat (210) et
dans lequel le procédé (100) comprend en outre l'enlèvement de la deuxième feuille de protection (219) de la première région de surface principale (212) du substrat (210) après la formation (120) du trou traversant (220 ; 220₁-220₈) dans le substrat (210).

5. Procédé (100) selon l'une des revendications susmentionnées,
dans lequel le dépôt (130) et la structuration du matériau conducteur sur la première région de surface principale (212) du substrat représente un dépôt structuré, de sorte que les premières pistes conductrices (230) soient formées sur la première région de surface principale (212) du substrat (210) ; et
dans lequel le dépôt (140) et la structuration du matériau conducteur supplémentaire sur la deuxième région de surface principale (214) du substrat représente un dépôt structuré, de sorte que les deuxièmes pistes conductrices (240) soient formées sur la deuxième région de surface principale (214) du substrat (210).

6. Procédé (100) selon la revendication 5,
dans lequel le dépôt structuré (130) du matériau conducteur sur la première région de surface principale (212) du substrat (210) est effectué de sorte que les premières pistes conductrices (230) présentent une épaisseur comprise entre 20 nm et 1 µm et
dans lequel le dépôt structuré (140) du matériau conducteur supplémentaire sur la deuxième région de surface principale (214) du substrat (210) est effectué de sorte que les deuxièmes pistes conductrices (240) présentent une épaisseur comprise entre 20 nm et 1 µm.

7. Procédé (100) selon la revendication 5 ou la revendication 6, dans lequel le procédé (100) comprend le nettoyage du substrat (210) avec le trou traversant (220 ; 220₁-220₈) avant le dépôt structuré (130) du matériau conducteur sur la première région de surface principale (212) du substrat (210) et le dépôt structuré (140) du matériau conducteur supplémentaire sur la deuxième région de surface principale (214) du substrat (210).

8. Procédé (100) selon la revendication 7, dans lequel le nettoyage du substrat (210) avec le trou traversant (220 ; 220₁-220₈) est effectué en utilisant un bain à ultrasons et/ou en utilisant un nettoyage de surface au plasma.

9. Procédé (100) selon l'une des revendications 5 à 8,
dans lequel le dépôt structuré (130) du matériau conducteur sur la première région de surface principale (212) du substrat (210) est effectué par impression en utilisant le trou traversant (220 ; 220₁-220₈) dans le substrat (210) comme référence pour l'alignement des premières pistes conductrices (230) ; et/ou
le dépôt structuré (140) du matériau conducteur supplémentaire sur la deuxième région de surface principale (214) du substrat (210) est effectué par impression, en utilisant le trou traversant (220 ; 220₁-220₈) dans le substrat (210) comme référence pour l'alignement des deuxièmes pistes conductrices (240).

10. Procédé (100) selon l'une des revendications 5 à 9,
dans lequel le dépôt structuré (130) du matériau conducteur sur la première région de surface principale (212) du substrat (210) est effectué par
le dépôt (132) du matériau conducteur sur la première région de surface principale (212) du substrat (210) pour recouvrir l'intégralité de la première région de surface principale (212) du substrat (210) avec une couche (133) de matériau conducteur et
la structuration (134, 134₁-134₅) de la couche (133) du matériau conducteur pour former les premières pistes conductrices (230) en utilisant le trou traversant (220 ; 220₁-220₈) dans le substrat (210) comme référence pour l'alignement des premières pistes conductrices (230) ;
et/ou
dans lequel le dépôt structuré (140) du matériau conducteur supplémentaire sur la deuxième région de surface principale (214) du substrat (210) est effectué par
le dépôt (142) du matériau conducteur supplémentaire sur la deuxième région de surface principale (214) du substrat (210) pour recouvrir l'intégralité de la deuxième région de surface principale (214) du substrat (210) avec une couche (143) du matériau conducteur supplémentaire et
la structuration (144, 144₁-144₅) de la couche (143) du matériau conducteur supplémentaire pour former les deuxièmes pistes conductrices (240) en utilisant le trou traversant (220 ; 220₁-220₈) dans le substrat (210) comme référence pour l'alignement des premières pistes conductrices (240).

11. Procédé (100) selon la revendication 10,
dans lequel le dépôt (132) du matériau conducteur sur la première région de surface principale (212) du substrat (210) pour former la couche (133) du matériau conducteur est effectué par pulvérisation ou par évaporation ;
et/ou
dans lequel le dépôt (142) du matériau conducteur supplémentaire sur la deuxième région de surface principale (214) du substrat (210) pour former la couche (143) du matériau conducteur supplémentaire est effectué par pulvérisation ou par évaporation.

12. Procédé (100) selon la revendication 10 ou la revendication 11,
dans lequel la structuration (134, 134₁-134₅) de la couche (133) du matériau conducteur est réalisée par lithographie ;
et/ou
dans lequel la structuration (144, 144₁-144₅) de la couche (143) du matériau conducteur supplémentaire est réalisée par lithographie.

13. Procédé (100) selon l'une des revendications 5 à 12,
dans lequel deux ou plusieurs trous traversants (220 ; 220₁-220₈) sont formés dans le substrat (210) entre la première (212) et la deuxième (214) région de surface principale du substrat (210) lors de la formation (120) du trou traversant (220 ; 220₁-220₈) ; et
dans lequel le dépôt structuré (130) de matériau conducteur sur la première région de surface principale (212) du substrat (210) est effectué, de sorte que les parois (222) des deux ou plusieurs trous traversants (220 ; 220₁-220₈) soient recouvertes par le matériau conducteur.

14. Procédé (100), comprenant
la fourniture (110) d'un substrat électriquement isolant (210), dans lequel le substrat (210) comprend un matériau isolant souple, et dans lequel le substrat (210) comprend une première feuille de protection (218) collée à une deuxième région de surface principale (214) du substrat (210) ;
la formation (120) d'un trou traversant (220 ; 220₁-220₈) dans le substrat (210) entre une première (212) et une deuxième (214) région de surface principale du substrat (210),
l'enlèvement de la première feuille de protection (218) de la deuxième zone de surface principale (214) du substrat (210) après la formation (120) du trou traversant (220 ; 220₁-220₈) dans le substrat (210) ;
le dépôt structuré (130) de matériau conducteur sur la première région de surface principale (212) du substrat (210), de sorte que les parois (222) du trou traversant (220 ; 220₁-220₈) soient recouvertes par le matériau conducteur et de sorte que des premières pistes conductrices (230) soient formées sur la première région de surface principale (212) du substrat (210) ; et
le dépôt structuré (140) de matériau conducteur supplémentaire sur la deuxième région de surface principale (214) du substrat (210), de sorte que des deuxièmes pistes conductrices (240) soient formées sur la deuxième région de surface principale (214) du substrat (210) ;
dans lequel le dépôt structuré (130) du matériau conducteur sur la première région de surface principale (212) du substrat (210) est effectué par impression en utilisant le trou traversant (220 ; 220₁-220₈) dans le substrat (210) comme référence pour l'alignement des premières pistes conductrices (230) ; et/ou
le dépôt structuré (140) du matériau conducteur supplémentaire sur la deuxième région de surface principale (214) du substrat (210) est effectué par impression, en utilisant le trou traversant (220 ; 220₁-220₈) dans le substrat (210) comme référence pour l'alignement des deuxièmes pistes conductrices (240).

15. Procédé (100), comprenant
la fourniture (110) d'un substrat électriquement isolant (210), dans lequel le substrat (210) comprend un matériau isolant souple, et dans lequel le substrat (210) comprend une première feuille de protection (218) collée sur une deuxième zone de surface principale (214) du substrat (210) ;
la formation (120) d'un trou traversant (220 ; 220₁-220₈) dans le substrat (210) entre une première (212) et une deuxième (214) région de surface principale du substrat (210),
l'enlèvement de la première feuille de protection (218) de la deuxième zone de surface principale (214) du substrat (210) après la formation (120) du trou traversant (220 ; 220₁-220₈) dans le substrat (210) ;
le dépôt structuré (130) de matériau conducteur sur la première région de surface principale (212) du substrat (210), de sorte que les parois (222) du trou traversant (220 ; 220₁-220₈) soient recouvertes par le matériau conducteur et de sorte que des premières pistes conductrices (230) soient formées sur la première région de surface principale (212) du substrat (210) ; et
le dépôt structuré (140) de matériau conducteur supplémentaire sur la deuxième région de surface principale (214) du substrat (210), de sorte que des deuxièmes pistes conductrices (240) soient formées sur la deuxième région de surface principale (214) du substrat (210) ;
dans lequel le dépôt structuré (130) du matériau conducteur sur la première région de surface principale (212) du substrat (210) est effectué par
le dépôt (132) du matériau conducteur sur la première région de surface principale (212) du substrat (210) pour recouvrir l'intégralité de la première région de surface principale (212) du substrat (210) avec une couche (133) de matériau conducteur et
la structuration (134, 134₁-134₅) de la couche (133) du matériau conducteur pour former les premières pistes conductrices (230) en utilisant le trou traversant (220 ; 220₁-220₈) dans le substrat (210) comme référence pour l'alignement des premières pistes conductrices (230) ;
et/ou
dans lequel le dépôt structuré (140) du matériau conducteur supplémentaire sur la deuxième région de surface principale (214) du substrat (210) est effectué par
le dépôt (142) du matériau conducteur supplémentaire sur la deuxième région de surface principale (214) du substrat (210) pour recouvrir l'intégralité de la deuxième région de surface principale (214) du substrat (210) avec une couche (143) du matériau conducteur supplémentaire et
la structuration (144, 144₁-144₅) de la couche (143) du matériau conducteur supplémentaire pour former les deuxièmes pistes conductrices (240) en utilisant le trou traversant (220 ; 220₁-220₈) dans le substrat (210) comme référence pour l'alignement des premières pistes conductrices (240).
